# EUROPEAN PATENT APPLICATION

(11) **EP 4 607 597 A1**
(43) Date of publication of application: **27.08.2025**
(21) Application number: 22962573.6
(22) Date of filing: 08.12.2022
(51) Int. Cl.: H01L 33/00, H01L 27/15

(54) **METHOD FOR MANUFACTURING ANTI-CROSSTALK STRUCTURE OF INTEGRATED COLOR MICRO LED**

(30) Priority: 21.10.2022 CN 202211290900
(71) Applicant: Fujian Prima Optoelectronics Co., Ltd., Fuzhou, Fujian 350000 (CN)
(72) Inventor: ZHANG, Fan, Fuzhou, Fujian 350000 (CN); ZHANG, Liqiang, Fuzhou, Fujian 350000 (CN); WU, Yongsheng, Fuzhou, Fujian 350000 (CN)
(74) Representative: Dall'Olio, Christian
(86) International application number: PCT/CN2022/137466
(87) International publication number: WO 2024/082397

(57) **Abstract**

The present invention discloses a fabrication method for a crosstalk-proof structure of an integrated colored Micro LED. A side, away from a base layer, of an integrated Micro LED chip with a common N electrode is covered with a black adhesive layer, the black adhesive layer is etched, and electrodes of the Micro LED chip are exposed, so that optical crosstalk between gallium nitride Mesas can be avoided; and a base layer is stripped, and N-type gallium nitride layers of a first Micro LED chip module are isolated, so that the N-type gallium nitride layers can be isolated by the black adhesive layer to avoid optical crosstalk inside an N-type gallium nitride material of a common N-type chip and optical crosstalk of the base part. In such a way, the problem of optical crosstalk on an LED light emitting optical path can be avoided.

## Description

### Technical Field

The present invention relates to the technical field of semiconductor electronics, in particular to a fabrication method for a crosstalk-proof structure of an integrated colored Micro LED.

### Background Art

All pixels of an integrated Micro LED are integrated on a base, and there is no segmentation operation such as cutting, which results in the problem of optical crosstalk between adjacent pixels, thereby affecting a display effect. The integrated Micro LED is generally made of common N-type gallium nitride, and a common N-type design also results in the problem of optical crosstalk existing in the N-type gallium nitride.

An existing integrated colored Micro LED technology is mainly formed by stacking an integrated blue and purple light gallium nitride (GaN) LED chip matrix light source and a QD (Quantum Dots) color conversion module, and there is the problem of optical crosstalk between Mesas of the GaN LED chip matrix light source, inside a common N-type GaN material, and on a sapphire base layer and other positions. There is also the problem of optical crosstalk among the QD of a QD module and in a gap between the QD module and a chip combination.

### Summary of the Invention

A technical problem to be solved by the present invention is to provide a fabrication method for a crosstalk-proof structure of an integrated colored Micro LED, by which the problem of optical crosstalk on an LED light emitting optical path can be avoided.

In order to solve the above-mentioned technical problem, the present invention adopts the technical solution that:
a fabrication method for a crosstalk-proof structure of an integrated colored Micro LED, includes the steps of:
covering a side, away from a base layer, of an integrated Micro LED chip with a common N electrode with a black adhesive layer, etching the black adhesive layer, and exposing electrodes of the Micro LED chip to obtain a first Micro LED chip module;
connecting the electrodes of the first Micro LED chip module with a driving substrate by bonding metals, removing the base layer of the first Micro LED chip module, and isolating N-type gallium nitride layers of the first Micro LED chip module to obtain a second Micro LED chip module;
filling an insulating colloid between the second Micro LED chip module and the driving substrate, and connecting all the N-type gallium nitride layers of the second Micro LED chip module with an N electrode of the driving substrate by using a transparent conductive layer; and
placing the light color conversion module on the transparent conductive layer on surfaces of the N-type gallium nitride layers to obtain the crosstalk-proof structure of the integrated colored Micro LED.

The present invention has the beneficial effects that: the side, away from the base layer, of the integrated Micro LED chip with the common N electrode is covered with the black adhesive layer, the black adhesive layer is etched, and the electrodes of the Micro LED chip are exposed, so that optical crosstalk between gallium nitride Mesas can be avoided; and a base is stripped, and the N-type gallium nitride layers of the first Micro LED chip module are isolated, so that the N-type gallium nitride layers can be isolated by the black adhesive layer to avoid optical crosstalk inside an N-type gallium nitride material of a common N-type chip and optical crosstalk of the base part. In such a way, the problem of optical crosstalk on an LED light emitting optical path can be avoided.

### Brief Description of the Drawings

Fig. 1 is a flow diagram of a fabrication method for a crosstalk-proof structure of an integrated colored Micro LED in an embodiment of the present invention;
Fig. 2 is a schematic diagram of an integrated Micro LED chip with a common N electrode in an embodiment of the present invention;
Fig. 3 is a schematic diagram of covering an integrated Micro LED chip with a common N electrode with a black adhesive layer in an embodiment of the present invention;
Fig. 4 is a schematic diagram of an etched black adhesive layer in an embodiment of the present invention;
Fig. 5 is a schematic diagram of combining a first Micro LED chip module with a driving substrate in an embodiment of the present invention;
Fig. 6 is a schematic diagram of stripping a first Micro LED chip module from a base in an embodiment of the present invention;
Fig. 7 is a schematic diagram of etching N-type gallium nitride layers on a first Micro LED chip module in an embodiment of the present invention;
Fig. 8 is a schematic diagram of covering a transparent conductive layer in an embodiment of the present invention;
Fig. 9 is a schematic diagram of a light color conversion module in an embodiment of the present invention; and
Fig. 10 is a schematic diagram of a crosstalk-proof structure of an integrated colored Micro LED in an embodiment of the present invention.

Description for reference numerals:
1, base layer; 2, buffer layer; 3, N-type gallium nitride layer; 4, P-type gallium nitride layer; 5, current spreading layer; 6 P electrode; 7, black adhesive layer; 8, driving substrate; 9, bonding metal; 10, insulating colloid; 11, transparent conductive layer; 12, N electrode; 13, glass; 14, reflector layer; 15, red quantum dot; 16, green quantum dot; 17, light exit hole; 18, protective layer; and 19, black light blocking tape.

### Detailed Description of the Invention

In order to describe the technical contents, achieved objects and effects of the present invention in detail, description will be shown below in conjunction with implementations and the accompanying drawings.

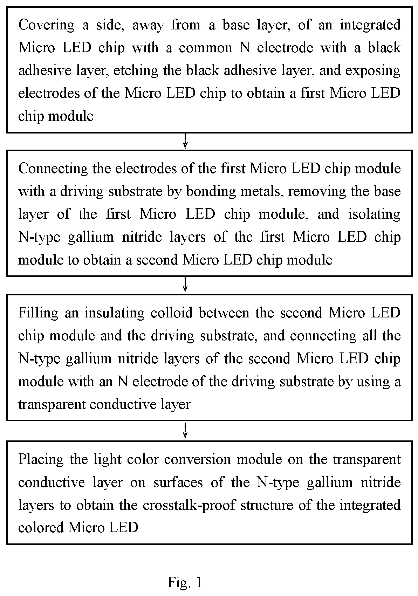

Refer to Fig. 1, an embodiment of the present invention provides a fabrication method for a crosstalk-proof structure of an integrated colored Micro LED, including the steps that:
a side, away from a base layer, of an integrated Micro LED chip with a common N electrode is covered with a black adhesive layer, the black adhesive layer is etched, and electrodes of the Micro LED chip are exposed to obtain a first Micro LED chip module;
the electrodes of the first Micro LED chip module are connected with a driving substrate by bonding metals, the base layer of the first Micro LED chip module is removed, and N-type gallium nitride layers of the first Micro LED chip module are isolated to obtain a second Micro LED chip module;
an insulating colloid is filled between the second Micro LED chip module and the driving substrate, and all the N-type gallium nitride layers of the second Micro LED chip module are connected with an N electrode of the driving substrate by using a transparent conductive layer; and
a light color conversion module is placed on the transparent conductive layer on surfaces of the N-type gallium nitride layers to obtain the crosstalk-proof structure of the integrated colored Micro LED.

It can be known from above that the present invention has the beneficial effects that: the side, away from the base layer, of the integrated Micro LED chip with the common N electrode is covered with the black adhesive layer, the black adhesive layer is etched, and the electrodes of the Micro LED chip are exposed, so that optical crosstalk between gallium nitride Mesas can be avoided; and a base is stripped, and the N-type gallium nitride layers of the first Micro LED chip module are isolated, so that the N-type gallium nitride layers can be isolated by the black adhesive layer to avoid optical crosstalk inside an N-type gallium nitride material of a common N-type chip and optical crosstalk of the base part. In such a way, the problem of optical crosstalk on an LED light emitting optical path can be avoided.

Further, the step that the black adhesive layer is etched, and electrodes of the Micro LED chip are exposed includes:
the black adhesive layer is etched until P electrodes of the Micro LED chip are exposed.

It can be known from above that the black adhesive layer is only etched selectively, but the P electrodes are not etched, in this way, the P electrodes will be naturally exposed after etching for a period of time, and thus, high reliability is achieved in a fabrication process.

Further, the step that the electrodes of the first Micro LED chip module are connected with a driving substrate by bonding metals includes:
the first Micro LED chip module is placed upside down, the electrodes of the first Micro LED chip module are connected with the bonding metals by one-to-one correspondence, and the bonding metals are connected with contact points of the driving substrate by one-to-one correspondence.

It can be known from above that the first Micro LED chip module is combined with the driving substrate in a metal bonding way after being placed upside down, and the bonding metals are used as connecting interfaces, which guarantees the reliability of chip driving connection.

Further, the step that N-type gallium nitride layers of the first Micro LED chip module are isolated includes:
the N-type gallium nitride layers are horizontally etched from a side away from the electrodes until the black adhesive layer is exposed.

It can be known from above that N-type gallium nitride layers of a common N-electrode chip are partially connected, and by horizontally etching the N-type gallium nitride layers, connected parts of the N-type gallium nitride layers can be etched, so that the remaining N-type gallium nitride layers are no longer connected and are isolated by the black adhesive layer, which further avoids the optical crosstalk inside the N-type gallium nitride material of the common N-type chip.

Further, the step that all the N-type gallium nitride layers are connected with an N electrode of the driving substrate by using a transparent conductive layer includes:
the transparent conductive layer is evaporated on outer surfaces of the black adhesive layer, the etched N-type gallium nitride layers, the insulating colloid, the driving substrate and the N electrode thereof.

It can be known from above that the transparent conductive layer is evaporated on surfaces of the chip module and the driving substrate, so that a common N-type transparent electrode can be obtained, and the electric conduction of the common N electrode can be achieved.

Further, before the step that the light color conversion module is placed on the transparent conductive layer on surfaces of the N-type gallium nitride layers, the fabrication method includes:
grooves are etched in glass according to positions of quantum dots, and a reflector layer is fabricated on surfaces of the grooves;
light exit holes with a first color are etched in positions, corresponding to first grooves, on the reflector layer, and quantum dots with a second color and quantum dots with a third color are respectively disposed on positions, corresponding to second grooves and third grooves, on the reflector layer to obtain a light color conversion structure; and
a protective layer is deposited on a side, away from the glass, of the light color conversion structure, and black light blocking tapes are fabricated on positions among the corresponding quantum dots on the protective layer and positions between the quantum dots and the light exit holes to obtain a light color conversion module.

It can be known from above that a selectively reflector layer is prefabricated on a glass base material, and the light exit holes with the first color, the quantum dots with the second color and the quantum dots with the third color are disposed, so that the light color conversion module only reflects an optical section with the first color; and the light color conversion module is completely isolated from the chip module by the black light blocking tapes, and no light leakage gaps are remained, so that optical crosstalk among the quantum dots of the light color conversion module and optical crosstalk between the light color conversion module and the chip are avoided.

Further, the first color is blue; and
the reflector layer includes silicon oxide and titanium oxide, and the reflector layer reflects light of 200-480 nm.

It can be known from above that the first color is blue, and the reflector layer reflects the light of 200-480 nm. Therefore, a reflecting layer only reflecting blue light and not reflecting red and green light can be fabricated on light emitting surfaces of the quantum dots by simple material stacking of silicon oxide and titanium oxide.

Further, the step that the light color conversion module is placed on the transparent conductive layer on surfaces of the N-type gallium nitride layers includes:
the light color conversion module is placed on the transparent conductive layer, wherein positions of the quantum dots of the light color conversion module are in one-to-one correspondence to positions of the N-type gallium nitride layers of the second Micro LED chip module.

It can be known from above that the crosstalk-proof structure of the integrated colored Micro LED can be obtained by combining the light color conversion module with the chip module.

Further, the black adhesive layer is a black epoxy adhesive layer.

It can be known from above that the black epoxy adhesive layer adopts an epoxy adhesive as a base material, which has a shaping ability to facilitate isolating the N-type gallium nitride layers.

Further, the transparent conductive layer is an indium tin oxide layer.

The above-mentioned fabrication method for a crosstalk-proof structure of an integrated colored Micro LED in the present invention is applicable to an integrated colored Micro LED chip to avoid the problem of optical crosstalk between Mesas, inside a common N-type gallium nitride material, on a base layer, among quantum dots of a QD module and in a gap between the QD module and a chip combination, which will be specifically described below with specific implementations:

### Embodiment 1

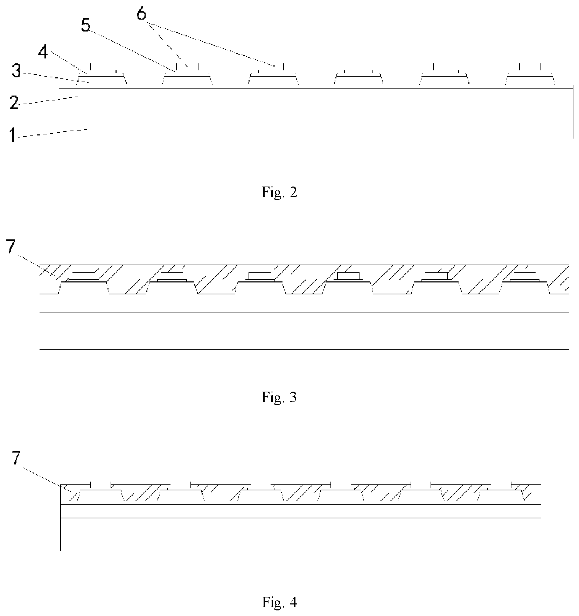

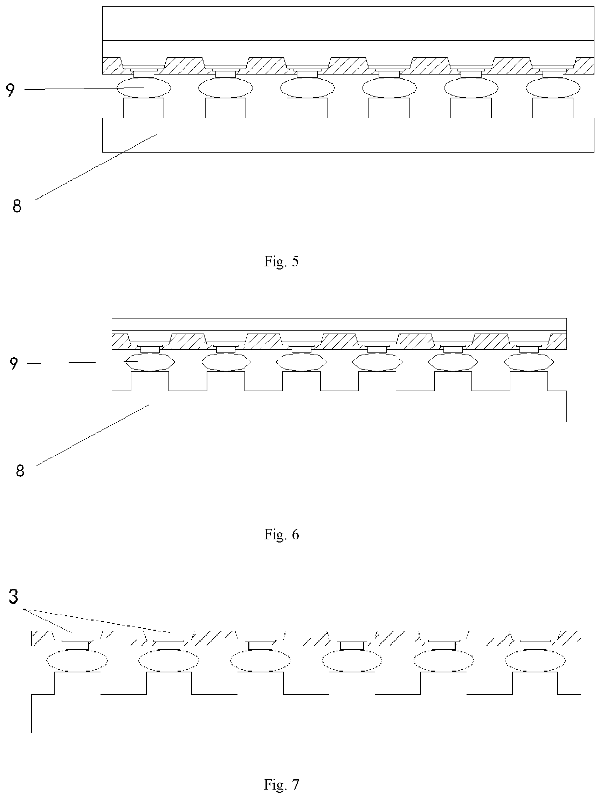

Refer to Fig. 1, a fabrication method for a crosstalk-proof structure of an integrated colored Micro LED, includes the steps that:
S1, a side, away from a base layer 1, of an integrated Micro LED chip with a common N electrode is covered with a black adhesive layer 7, the black adhesive layer 7 is etched, and electrodes of the Micro LED chip are exposed to obtain a first Micro LED chip module.
S11, refer to Fig. 2, the integrated Micro LED chip with the common N electrode is fabricated by using a GaN-based epitaxial wafer, the Micro LED chip includes a buffer layer 2, N-type gallium nitride layers 3 and P-type gallium nitride layers 4 sequentially growing on the base layer 1, the N-type gallium nitride layers 3 and the P-type gallium nitride layers 4 are graphically etched so that the N-type gallium nitride layers 3 are partially connected; and current spreading layers 5 and P electrodes 6 sequentially grow on the P-type gallium nitride layers 4.
S12, refer to Fig. 3, the black adhesive layer 7 with an epoxy base is coated on an entire side of the integrated Micro LED chip with the common N electrode, and etching will be performed after levelling.
S13, refer to Fig. 4, the black adhesive layer 7 is etched until the P electrodes 6 of the Micro LED chip are exposed; and in the present embodiment. By means of ICP etching, a colloid can be only etched selectively, but the electrodes cannot be etched, in this way, the electrodes will be naturally exposed out of the etched black adhesive layer 7 after etching for a period of time.
S2, the electrodes of the first Micro LED chip module are connected with a driving substrate 8 by bonding metals 9, the base layer 1 of the first Micro LED chip module is removed, and the N-type gallium nitride layers 3 of the first Micro LED chip module are isolated to obtain a second Micro LED chip module.
S21, refer to Fig. 5, the first Micro LED chip module is placed upside down, the electrodes of the first Micro LED chip module are connected with the bonding metals 9 by one-to-one correspondence, and the bonding metals 9 are connected with contact points of the driving substrate 8 by one-to-one correspondence.

In the present embodiment, the first Micro LED chip module is combined with the driving substrate 8 in a metal bonding way, and the bonding metals 9 are used as connecting interfaces.

S22, refer to Fig. 6, the base layer 1 is removed by laser stripping.

S23, refer to Fig. 7, the N-type gallium nitride layers 3 are horizontally etched from a side away from the electrodes until the black adhesive layer 7 is exposed.

Specifically, the buffer layer 2 is removed by the ICP etching, and parts of the N-type gallium nitride layers 3 are etched. The N-type gallium nitride layers 3 remained after etching have been unconnected, and the black adhesive layer 7 is filled among all the N-type gallium nitride layers 3.

S3, an insulating colloid 10 is filled between the second Micro LED chip module and the driving substrate 8, and all the N-type gallium nitride layer of the second Micro LED chip module are connected with an N electrode 12 of the driving substrate 8 by using a transparent conductive layer 11.

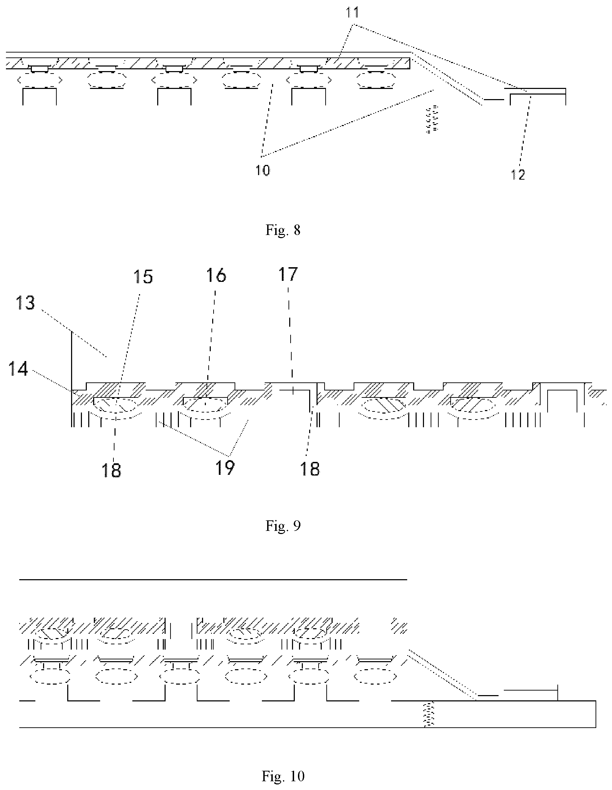

Specifically, refer to Fig. 8, the transparent conductive layer 11 is evaporated on outer surfaces of the black adhesive layer 7, the etched N-type gallium nitride layers 3, the insulating colloid 10, the driving substrate 8 and the N electrode 12 thereof.

In the present embodiment, the transparent conductive layer 11 is an indium tin oxide layer which is coated with a film by sputtering or reactive plasma deposition (RPD); and specifically, after etching, the insulating colloid 10 is filled between the chip module and the driving substrate, and the N-type gallium nitride layers are connected with the N electrode 12 of the driving substrate by using an indium tin oxide material.

S4, a light color conversion module is placed on the transparent conductive layer 11 on surfaces of the N-type gallium nitride layers 3 to obtain the crosstalk-proof structure of the integrated colored Micro LED.

S41, refer to Fig. 9, a light color conversion module is fabricated:
S411, grooves are etched in glass 13 according to positions of quantum dots, and a reflector layer 14 is fabricated on surfaces of the grooves, wherein depths of the grooves are 500-5000 µm;
S412, light exit holes 17 with a first color are etched in positions, corresponding to first grooves, on the reflector layer 14, and quantum dots with a second color and quantum dots with a third color are respectively disposed on positions, corresponding to second grooves and third grooves, on the reflector layer 14 to obtain a light color conversion structure;
in the present embodiment, the first color is blue, the second color is red, and the third color is green; that is, the blue light exit holes 17 are reserved, the red quantum dots 15 and the green quantum dots 16 are fabricated; wherein light emitting positions corresponding to the red and green quantum dots are provided with masks for protection and are not etched;
the reflector layer 14 is made of main materials including silicon oxide and titanium oxide, only reflects light of 200-480 nm and does not reflect rays of 480-800 nm according to an optical principle of a distributed Bragg reflector; and
S413, a protective layer 18 resistant to temperature, humidity and corrosion is deposited on a side, away from the glass 13, of the light color conversion structure by ALD (Atomic Layer Deposition), and black light blocking tapes 19 are fabricated on positions among the corresponding quantum dots on the protective layer 18 and positions between the quantum dots and the light exit holes 17 by photoetching to obtain a light color conversion module.
S42, refer to Fig. 10, the light color conversion module fabricated above is combined with the chip module to obtain the crosstalk-proof structure of the integrated colored Micro LED. Positions of the quantum dots of the light color conversion module are in one-to-one correspondence to positions of the N-type gallium nitride layers of the second Micro LED chip module.

Compared with a traditional Micro LED structure, the present embodiment retains the convenience of integrated processing, while the problem of optical crosstalk on all light emitting optical paths is avoided; it is convenient to achieve design, and RGB color distribution can be combined according to actual demands; and protectiveness is extremely good, the QD (quantum dots) and a gallium nitride chip are protected well; and the process of processing the chip module is reasonable, and the good shaping performance of the epoxy adhesive and the convenience of doping black are utilized.

In conclusion, according to the fabrication method for a crosstalk-proof structure of an integrated colored Micro LED provided in the present invention, a side, away from a base layer, of an integrated Micro LED chip with a common N electrode is covered with a black adhesive layer, the black adhesive layer is etched, and electrodes of the Micro LED chip are exposed, so that optical crosstalk between gallium nitride Mesas can be avoided; and a base is stripped, and N-type gallium nitride layers of a first Micro LED chip module are isolated, and the isolated N-type gallium nitride layers are connected with an N electrode on a driving substrate by using a transparent conductive layer to form a transparent common N electrode, so that optical crosstalk inside an N-type gallium nitride material of a common N-type chip and optical crosstalk of the base part are avoided; and a colored LED is achieved by means of a light color conversion device, wherein a reflecting layer only reflecting blue light and not reflecting red and green light is fabricated on light emitting surfaces of the quantum dots by simple material stacking of silicon oxide and titanium oxide. In such a way, the problem of optical crosstalk on an LED light emitting optical path can be avoided.

Above descriptions are merely embodiments of the present invention, and are not intended to hence limit the patent scope of the present invention. Any equivalent transformations made according to the contents of the description and the accompanying drawings of the present invention are directly or indirectly applied to the related art and also fall within the patent protection scope of the present invention in a similar way.

## Claims

1. A fabrication method for a crosstalk-proof structure of an integrated colored Micro LED, **characterized by** comprising the following steps of:
covering a side, away from a base layer, of an integrated Micro LED chip with a common N electrode with a black adhesive layer, etching the black adhesive layer, and exposing electrodes of the Micro LED chip to obtain a first Micro LED chip module;
connecting the electrodes of the first Micro LED chip module with a driving substrate by bonding metals, removing the base layer of the first Micro LED chip module, and isolating N-type gallium nitride layers of the first Micro LED chip module to obtain a second Micro LED chip module;
filling an insulating colloid between the second Micro LED chip module and the driving substrate, and connecting all the N-type gallium nitride layers of the second Micro LED chip module with an N electrode of the driving substrate by using a transparent conductive layer;
placing the light color conversion module on the transparent conductive layer on surfaces of the N-type gallium nitride layers to obtain the crosstalk-proof structure of the integrated colored Micro LED.

2. The fabrication method for a crosstalk-proof structure of an integrated colored Micro LED according to claim 1, **characterized in that** the etching the black adhesive layer, and exposing electrodes of the Micro LED chip comprises:
etching the black adhesive layer until P electrodes of the Micro LED chip are exposed.

3. The fabrication method for a crosstalk-proof structure of an integrated colored Micro LED according to claim 1, **characterized in that** the connecting the electrodes of the first Micro LED chip module with a driving substrate by bonding metals comprises:
placing the first Micro LED chip module upside down, connecting the electrodes of the first Micro LED chip module with the bonding metals by one-to-one correspondence, and connecting the bonding metals with contact points of the driving substrate by one-to-one correspondence.

4. The fabrication method for a crosstalk-proof structure of an integrated colored Micro LED according to claim 1, **characterized in that** the isolating N-type gallium nitride layers of the first Micro LED chip module comprises:
horizontally etching the N-type gallium nitride layers from a side away from the electrodes until the black adhesive layer is exposed.

5. The fabrication method for a crosstalk-proof structure of an integrated colored Micro LED according to claim 4, **characterized in that** the connecting all the N-type gallium nitride layers with an N electrode of the driving substrate by using a transparent conductive layer comprises:
evaporating the transparent conductive layer on outer surfaces of the black adhesive layer, the etched N-type gallium nitride layers, the insulating colloid, the driving substrate and the N electrode thereof.

6. The fabrication method for a crosstalk-proof structure of an integrated colored Micro LED according to claim 1, **characterized in that** before the step that the light color conversion module is placed on the transparent conductive layer on surfaces of the N-type gallium nitride layers, the fabrication method includes:
etching grooves in glass according to positions of quantum dots, and fabricating a reflector layer on surfaces of the grooves;
etching light exit holes with a first color in positions, corresponding to first grooves, on the reflector layer, and respectively disposing quantum dots with a second color and quantum dots with a third color on positions, corresponding to second grooves and third grooves, on the reflector layer to obtain a light color conversion structure;
depositing a protective layer on a side, away from the glass, of the light color conversion structure, and fabricating black light blocking tapes on positions among the corresponding quantum dots on the protective layer and positions between the quantum dots and the light exit holes to obtain a light color conversion module.

7. The fabrication method for a crosstalk-proof structure of an integrated colored Micro LED according to claim 6, **characterized in that** the first color is blue; and
the reflector layer comprises silicon oxide and titanium oxide, and the reflector layer reflects light of 200-480 nm.

8. The fabrication method for a crosstalk-proof structure of an integrated colored Micro LED according to claim 6, **characterized in that** the placing the light color conversion module on the transparent conductive layer on surfaces of the N-type gallium nitride layers comprises:
placing the light color conversion module on the transparent conductive layer, wherein positions of the quantum dots of the light color conversion module are in one-to-one correspondence to positions of the N-type gallium nitride layers of the second Micro LED chip module.

9. The fabrication method for a crosstalk-proof structure of an integrated colored Micro LED according to claim 1, **characterized in that** the black adhesive layer is a black epoxy adhesive layer.

10. The fabrication method for a crosstalk-proof structure of an integrated colored Micro LED according to claim 1, **characterized in that** the transparent conductive layer is an indium tin oxide layer.

## Amended claims

### Amended claims under Art. 19.1 PCT

1. A fabrication method for a crosstalk-proof structure of an integrated colored Micro LED, **characterized by** comprising the following steps of:
covering a side, away from a base layer, of an integrated Micro LED chip with a common N electrode with a black adhesive layer, etching the black adhesive layer, and exposing electrodes of the Micro LED chip to obtain a first Micro LED chip module;
connecting the electrodes of the first Micro LED chip module with a driving substrate by bonding metals, removing the base layer of the first Micro LED chip module, and isolating N-type gallium nitride layers of the first Micro LED chip module to obtain a second Micro LED chip module;
filling an insulating colloid between the second Micro LED chip module and the driving substrate, and connecting all the N-type gallium nitride layers of the second Micro LED chip module with an N electrode of the driving substrate by using a transparent conductive layer;
etching grooves in glass according to positions of quantum dots, and fabricating a reflector layer on surfaces of the grooves;
etching light exit holes with a first color in positions, corresponding to first grooves, on the reflector layer, and respectively disposing quantum dots with a second color and quantum dots with a third color on positions, corresponding to second grooves and third grooves, on the reflector layer to obtain a light color conversion structure;
depositing a protective layer on a side, away from the glass, of the light color conversion structure, and fabricating black light blocking tapes on positions among the corresponding quantum dots on the protective layer and positions between the quantum dots and the light exit holes to obtain a light color conversion module; and
placing the light color conversion module on the transparent conductive layer on surfaces of the N-type gallium nitride layers to obtain the crosstalk-proof structure of the integrated colored Micro LED.

2. The fabrication method for a crosstalk-proof structure of an integrated colored Micro LED according to claim 1, **characterized in that** the etching the black adhesive layer, and exposing electrodes of the Micro LED chip comprises:
etching the black adhesive layer until P electrodes of the Micro LED chip are exposed.

3. The fabrication method for a crosstalk-proof structure of an integrated colored Micro LED according to claim 1, **characterized in that** the connecting the electrodes of the first Micro LED chip module with a driving substrate by bonding metals comprises:
placing the first Micro LED chip module upside down, connecting the electrodes of the first Micro LED chip module with the bonding metals by one-to-one correspondence, and connecting the bonding metals with contact points of the driving substrate by one-to-one correspondence.

4. The fabrication method for a crosstalk-proof structure of an integrated colored Micro LED according to claim 1, **characterized in that** the isolating N-type gallium nitride layers of the first Micro LED chip module comprises:
horizontally etching the N-type gallium nitride layers from a side away from the electrodes until the black adhesive layer is exposed.

5. The fabrication method for a crosstalk-proof structure of an integrated colored Micro LED according to claim 4, **characterized in that** the connecting all the N-type gallium nitride layers with an N electrode of the driving substrate by using a transparent conductive layer comprises:
evaporating the transparent conductive layer on outer surfaces of the black adhesive layer, the etched N-type gallium nitride layers, the insulating colloid, the driving substrate and the N electrode thereof.

6. The fabrication method for a crosstalk-proof structure of an integrated colored Micro LED according to claim 1, **characterized in that** the first color is blue; and
the reflector layer comprises silicon oxide and titanium oxide, and the reflector layer reflects light of 200-480 nm.

7. The fabrication method for a crosstalk-proof structure of an integrated colored Micro LED according to claim 1, **characterized in that** the placing the light color conversion module on the transparent conductive layer on surfaces of the N-type gallium nitride layers comprises:
placing the light color conversion module on the transparent conductive layer, wherein
positions of the quantum dots of the light color conversion module are in one-to-one correspondence to positions of the N-type gallium nitride layers of the second Micro LED chip module.

8. The fabrication method for a crosstalk-proof structure of an integrated colored Micro LED according to claim 1, **characterized in that** the black adhesive layer is a black epoxy adhesive layer.

9. The fabrication method for a crosstalk-proof structure of an integrated colored Micro LED according to claim 1, **characterized in that** the transparent conductive layer is an indium tin oxide layer.
